# EUROPEAN PATENT APPLICATION

(11) **EP 1 755 073 A2**
(43) Date of publication of application: **21.02.2007**
(21) Application number: 06119025.2
(22) Date of filing: 16.08.2006
(51) Int. Cl.: G06K 19/077

(54) **RFID inlays and methods of their manufacture**

(30) Priority: 16.08.2005 US 205545; 31.10.2005 US 263888
(71) Applicant: X-CYTE, Incorporated, San Jose, CA 95119 (US)
(72) Inventor: Cocita, Keith, Santa Cruz, CA 95060 (US); Reis, Antonio, L., Modesto, CA 95358 (US)
(74) Representative: Poulin, Gérard

(57) **Abstract**

A method of manufacturing RFID inlay structures includes providing a strap substrate containing an RFID chip. Strap pad patterns are formed adjacent said recessed regions over contacts of the RFID chip using a directly electroplateable resin (DER). The strap substrate is attached to an inlay substrate having an electrically conductive antenna and antenna contact patterns. The DER strap pad patterns, antenna pattern, antenna contacts and chip contacts are electroplated, thereby forming a metal interconnect between the contacts of the RFID chip and the antenna contacts on the inlay substrate. The strap substrate may be obtained from a web of strap substrates formed by a casting process. The DER material may be in the form of a DER ink and applied using a penplotter apparatus to form strap pad patterns or antenna coil patterns on the strap substrate, and to form antenna features and antenna contact patterns on the inlay substrate.

## Description

### CROSS-REFERENCE TO RELATED APPLICATIONS

This application is related to and hereby claims priority from U.S. Patent Application No. 11/205,545, filed August 16, 2005, and U.S. Patent Application No. 11/263,888, filed October 31, 2005.
FIELD OF THE INVENTION

The present invention relates to radio frequency identification (RFID). More particularly, the present invention relates to RFID inlays and methods of their manufacture.
BACKGROUND OF THE INVENTION

Radio frequency identification (RFID) is a technology having many applications including, for example, inventory control, supply chain management, and anti-theft of merchandise in stores.

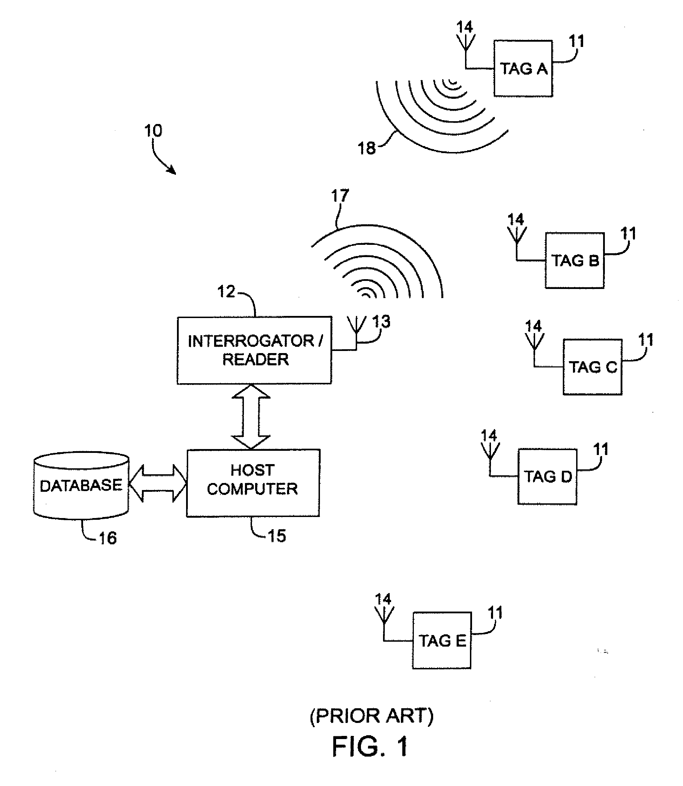

A typical RFID system 10 comprises a plurality of transponders (or "tags") 11 and one or more transceivers (referred to in the art as "interrogators" or "readers") 12, as illustrated in FIG. 1. The tags 11 are attached to objects, such as for example, products in a supermarket. An interrogator/reader 12 includes an antenna 13. The tags 11 also have their own respective antennas 14. The interrogator/reader 12 "interrogates" a particular tag 11 by transmitting a radio frequency interrogation signal 17 to the tag (e.g. TAG A in FIG. 1). The interrogation signal 17 activates the interrogated tag, which then transmits or reflects a radio frequency signal 18 carrying a unique identifier or other related information back to the interrogator/reader 12. The interrogator/reader 12 "reads" the information by demodulating the radio frequency signal 18. The information is then either communicated directly to a host computer 15 and stored in a database 16, or is stored locally in the interrogator/reader 12 and later uploaded to the host computer 15 for processing.

Although the technology necessary to implement RFID has existed for many years, not until recently has it begun to come into widespread use. The principle reason for the delay relates to the difficulty in manufacturing inexpensive tags. Many believe that widespread use of RFID will require finished tags that sell for five to ten cents or less.

In the past few years, enormous efforts have been dedicated toward the goal of producing inexpensive RFID tags. An RFID tag comprises: (1) an RFID integrated circuit (or "chip"), which contains circuitry and memory for storing the unique identifiers and possibly other information; (2) a substrate upon which the RFID chip is mounted; and (3) an antenna that is properly tuned for communication with the interrogator/reader. While substantial strides have been made in reducing the costs involved in fabricating the RFID chips, inexpensive methods of assembling the RFID chips with the remaining components that make up the tag have lagged. In other words, expensive assembly and manufacturing costs remain as bottlenecks to achieving the economies of scale necessary to render RFID economically feasible. Various of the assembly and manufacturing challenges faced by RFID tag manufactures, and some of the attempts to overcome the challenges are described below.

RFID chips are manufactured using integrated circuit technology. The size of a resulting RFID chip may be as small as the size of a grain of salt. By contrast, the required length of a typical RFID tag antenna may be on the order of 100 mm. This length of antenna is necessary for the antenna to be able to transmit and receive radio frequency signals of the wavelength used in RFID systems. Consequently, in nearly all applications, the antenna dimensions prohibit integration of the antenna in the RFID chip fabrication process. The antenna must therefore be manufactured separately, i.e. on a separate substrate, and then somehow assembled with and electrically connected to the RFID chip.

One known method of assembling an RFID chip to its respective antenna employs a robot to precisely position contacts of the RFID chip to contact positions of the RFID tag antenna formed on an antenna substrate. Once properly positioned, a bonding process is performed to form a permanent electrical connection between the chip contacts and the antenna. Because the dimensions of the RFID chip and its contacts are extremely small compared to the dimensions of the antenna, the process of properly aligning the chip contacts to the antenna contact positions is slow and tedious. Further, because the chips are so small, even very sophisticated robots have difficulty picking up and handling the chips.

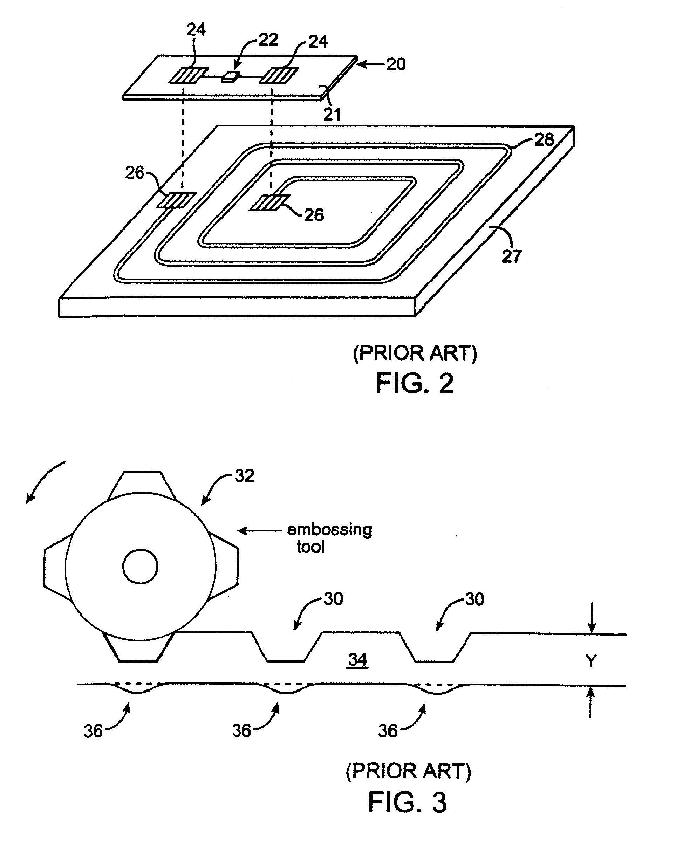

To avoid the precision and tedium of connecting the RFID chip contacts to antenna contact positions, state of the art RFID assembly methods produce and employ an intermediate structure known as a "strap". As shown in FIG. 2, a strap 20 comprises an RFID chip 22, a substrate 21 that functions as a carrier of the RFID chip, and electrically conductive pads 24 formed on the strap substrate surface. As explained in more detail below, the pads 24 on the strap substrate 21 are used to electrically connect the chip contacts to the antenna contact positions 26 on an antenna substrate 27. Because the strap pads 24 are much larger and spaced a greater distance apart than the chip contacts are, forming an electrical connection between the chip contacts and the antenna 28 is substantially less difficult than forming the connections without the benefit of the strap 20.

A plurality of strap substrates may be formed in a single operation by embossing a long strip or web of substrate material using an embossing tool. Such an approach is shown in FIG. 3. According to this technique, a plurality of recessed regions 30 is formed by rolling an embossing tool 32 over a rigid or semi-rigid substrate 34 and applying pressure and/or heat. The recessed regions 30 are of a predetermined size approximating the dimensions of the chip. A drawback of the embossing tool is that sophisticated equipment and machinery are needed to apply and control the applied pressure and/or heat. Typically the substrate material is heated and cooled under pressure for efficient embossing. However, to achieve these enhanced efficiencies the equipment is necessarily large and lacks flexibility.

Another drawback of the embossing approach is that, unless the thickness, Y, of the substrate material is large enough, embossing the topside of the substrate 34 results in protrusions 36 extending out from the backside surface of the substrate 34 and/or strained areas around the embossed features, and the strained areas result in high yield loss. The protrusions 36 also make it difficult to assemble the strap to the antenna substrate. The protrusions 36 can be avoided by using a more rigid substrate material or by increasing the thickness Y. However, increased rigidity makes embossing more difficult. Increased rigidity or thickness Y of the substrate also prevents the substrate from being rolled onto a reel. In some applications, it is desirable to form straps on a flexible substrate that can be rolled onto a reel. This allows for easier handling and delivery to customers.

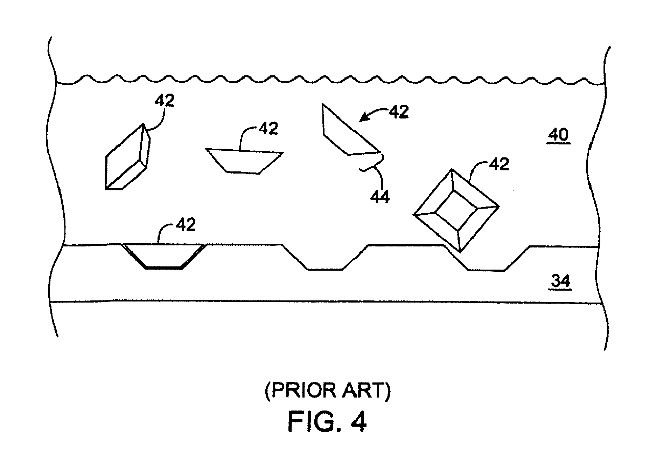

After the recessed regions 30 have been formed, individual RFID chips are placed in the recessed regions 30 by hand or by a robot (similar to as described above). Alternatively, the RFID chips are assembled into the recessed regions using a process known as fluidic self-assembly (FSA). As illustrated in FIG. 4, the FSA process involves flowing a slurry 40 containing numerous RFID chips 42 over the surface of the strap substrate 34 having the recessed regions 30. Gravity pulls the RFID chips into the recessed regions 30. As shown in FIG. 4, edges 44 of the RFID chips 42 may be beveled so that they more easily fall into the recessed regions 30 with the correct orientation.

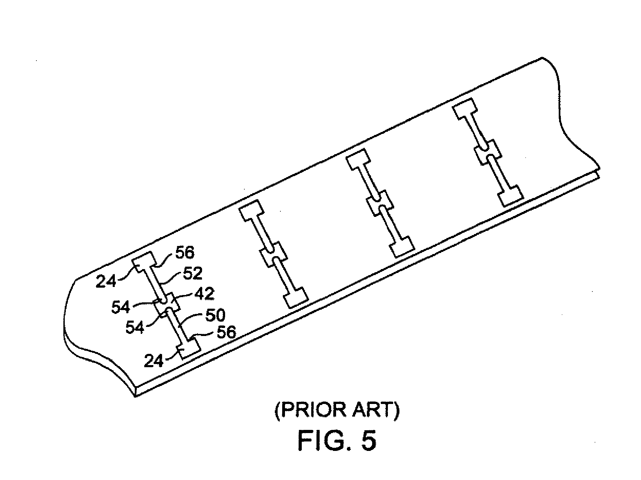

Once the RFID chips have been positioned in the recessed regions 30, leads for connecting the contacts of the chips to the antenna contact positions are then formed adjacent to the recessed regions in the strap substrate. As shown in FIG. 5, typically first and second leads 50 and 52 are formed for each RFID chip 42. The first and second leads 50, 52 both have proximate ends 54 that electrically connect to the RFID chip contacts (not shown) and distal ends 56. The first and second leads 50, 52 are formed so that they extend in opposite directions away from the RFID chip 42 and toward the longitudinal edges of the substrate, where they terminate in the form of pads (i.e. pads 24).

There are various prior art techniques available for forming the interconnecting leads 50, 52 and pads 24. According to one technique, the leads and pads are formed by a photoresist, cure, and etching process, similar to that used in the manufacture of integrated circuits. Unfortunately, the photoresist, cure, and etching process requires multiple steps and is slow. Such a process is also environmentally unfriendly, since it uses harmful chemicals and generates byproducts that are both harmful to the manufacturer and to the environment. Finally, compared to other known techniques, the process is expensive.

A second prior art technique for forming the interconnecting leads and pads is described in U.S. Patent No. 6,867,983 ('983 Patent). According to this second technique, a catalyst layer is selectively formed on the substrate where the leads and pads are to be located. After the catalyst layer is activated, a metal, such as copper, is plated on the activated layers using an electroless plating process. The '983 patent explains that the catalyst layer is made up of elements from Group 1B or VIII of the periodic table. A variety of suitable materials that can be used for the catalyst layer include PVC powder, palladium dichloride bisacetonitrile (PdC12BAN), lithium chloride (LiCl) in tetrahydorfuran (THF) solution, PdCl₂, and Pd(NO₃)₂.

A major drawback of the prior art technique described in the '983 Patent is that it is slow. Electroless plating techniques also require extensive process lines requiring high water consumption, are waste intensive, and generate large amounts of toxic waste.

Not only are the process steps needed to form and cure the catalyst layer time intensive, but additional time-consuming operations, even after the electroless plating process has been completed, are required to form the electrical interconnections between the strap pads to the antenna contact position of the antenna. (The structure resulting from the mechanical and electrical assembly of the strap to the antenna substrate is often referred to in the art as the "RFID inlay".) Electroless plating cannot be used to reliably form electrical interconnects between the conductive pads on the strap and the antenna contacts on the antenna substrate because it has poor bridging capabilities.

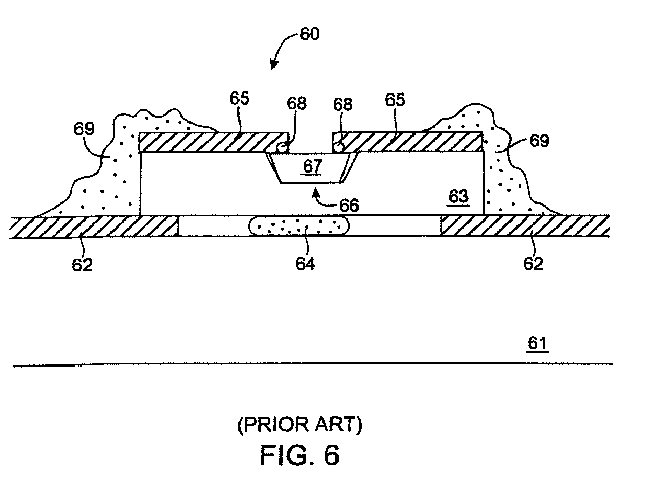

Because of the poor bridging capabilities of electroless plating, a conductive epoxy (e.g. a silver filled epoxy paste) is typically used to form the electrical interconnections between electroless plated strap pads and the antenna contact positions. FIG. 6 shows a prior art RFID inlay 60 in which a conductive epoxy is used to form electrical interconnections between the electroless plated strap pads and antenna contacts. The RFID inlay 60 includes an antenna substrate 61 having antenna contacts 62. A strap substrate 63 is physically mounted and secured to the antenna substrate 61 by an adhesive 64. The strap substrate 63 includes electroless plated strap pads 65, and a recessed region 66 within which an RFID chip 67 is held. The electroless plated strap pads 65 are electrically connected to chip contacts 68 of the RFID chip 67. A conductive epoxy 69 is formed between the electroless plated strap pads 65 on the strap substrate 63 and the antenna contacts 62 on the antenna substrate 61.

Although conductive epoxies may be used to form the electrical interconnects between the strap pads and the antenna contacts, multiple processing steps are still needed to complete the electrical interconnections and the mechanical assembly of the RFID inlay. Further, because the conductive adhesives must cure over a period of time (typically minutes or even hours), completed RFID inlays cannot be tested immediately following assembly. With production rates measured in thousands of units per hour, this means that any delay in testing can result in substantial yield losses before a defect in the manufacturing process is detected.

While prior art techniques of manufacturing and assembling RFID tags have progressed in the last few years, the cost of the resulting RFID tags still remains high. Accordingly, improved manufacturing methods for forming and assembling inexpensive RFID tags, including improved manufacturing methods for forming RFID inlays of RFIG tags, are still needed.
SUMMARY OF THE INVENTION

RFID inlay structures and methods of their manufacture are disclosed. An exemplary RFID inlay structure comprises an inlay substrate having an antenna and antenna contacts; a strap substrate carrying an RFID chip and having at least one surface coated with a directly electroplateable resin (DER) or other electrically conductive material; and an electroplated metal interconnection layer interconnecting contacts of the RFID chip to the antenna contacts on the inlay substrate.

According to an aspect of the invention, a method of manufacturing an RFID inlay structure includes providing a strap substrate having a recessed region for accommodating an RFID chip. Strap pad patterns, adjacent to the recessed regions, are formed from known prior art techniques or using a directly electroplateable resin (DER). The strap substrate is then attached to an inlay substrate having an electrically conductive antenna and antenna contact patterns. The strap pad patterns, antenna pattern and antenna contacts, any of which may be formed using DER, are electroplated. In this manner a seamless metal interconnect is formed between contacts of the RFID chip and the antenna contacts on the inlay substrate, thereby eliminating the need to deposit conductive epoxies or glues to achieve the electrical interconnection between the chip contacts and the antenna contacts.

According to another aspect of the invention, the strap substrate may be obtained from a web or sheet of strap substrates formed by a casting process. The casting process comprises casting a low viscosity material onto a casting drum or conveyor having predetermined casting patterns. The substrates are formed by curing the low viscosity material (e.g., using one or more ultraviolet sources, heat or other methods) as the material is conveyed around the casting drum or conveyor. RFID chips may then be assembled into the recessed regions of the strap substrate (web or sheet form) using a fluidic self-assembly (FSA), vibration self-assembly, or other suitable technique. Depending on the orientation of the RFID chip contacts (i.e. facing towards the bottom of the recess or facing upwards), assembly is performed prior to or after the strap pad patterns (and possibly other features, e.g., loop antenna patterns) are formed on the substrate (web or sheet). Edges of the strap substrate may also be dipped into a DER solution in preparation of an electroplating process. The DER coated edges facilitate the electroplating to form seamless metal coverage of all required electrical paths. After assembly, the web or sheet of strap substrates may then be either plated or separated into long strips, each strip having a succession of strap substrates with corresponding RFID chips in associated recessed regions and corresponding strap pad patterns or loop antenna patterns.

According to another aspect of the invention, the DER material is formulated to form a DER ink capable of being applied to the web of strap substrates to form strap pad patterns or loop antenna patterns. DER may also be used to form antenna features and antenna contact patterns on the inlay substrate. The DER ink may also be formulated so that it can be applied by a pen of a pen-plotter apparatus. The DER ink comprises a binder or co-binder and at least one conductive powder having a mean particle size of less than 2 microns or less. The conductive powder may contain carbon black and/or graphite. Use of graphite may also operate as a lubricant to provide lubrication for the pen of the pen-plotter apparatus.

According to another aspect of the invention, DER antenna loop patterns are formed on the same substrate that the RFID chips are mounted. The RFID chips are mounted to the substrate prior to forming the DER antenna loop patterns. Then, by using a plotter pen type device and a DER ink, the antenna loop patterns are formed. The DER ink is also applied onto the RFID chip contacts. One or more bus bars are also formed on the substrate using the DER ink to facilitate an electroplating process that electroplates the antenna loop patterns and the DER that was applied to the RFID chip contacts.

Other aspects of the invention are described and claimed below, and a further understanding of the nature and advantages of the invention may be realized by reference to the remaining portions of the specification and the attached drawings.
BRIEF DESCRIPTION OF THE DRAWINGS

FIG. 1 is a conceptual drawing of a conventional RFID system.

FIG. 2 is a perspective view drawing of a prior art RFID inlay substrate having an antenna and its association with a strap containing an RFID chip.

FIG. 3 is a drawing illustrating a known embossing technique used to form recessed regions in a strap substrate.

FIG. 4 is a drawing illustrating a prior art fluidic self-assembly (FSA) technique.

FIG. 5 is a perspective drawing of a plurality of recesses, for holding a corresponding plurality of RFID chips, and associated leads for electrically interconnecting contacts of the RFID chips to antenna contact positions on an inlay substrate.

FIG. 6 is a cross-sectional drawing of a prior art RFID inlay that employs a conductive epoxy or conductive glue to form the electrical interconnections between electroless plated strap pads of a strap substrate and antenna contacts of an antenna substrate.

FIG. 7 is a cross-sectional drawing of an RFID inlay structure, according to an embodiment of the present invention.

FIG. 8 is a drawing of a casting technique that uses a casting drum, which can be used to form a web containing a plurality of strap substrates, in accordance with the present invention.

FIG. 9 is a drawing of a casting technique that uses conveyor having a casting belt, which can be used to form a web containing a plurality of strap substrates, in accordance with the present invention.

FIG. 10 is a perspective view drawing of a web containing a plurality of recessed regions formed, for example, by the casting technique shown in FIG. 8 or the belt-conveyor casting technique shown in FIG. 9.

FIG. 11 is a flow diagram illustrating the manufacture of a directly electroplateable resin (DER) ink that is suitable for application by a pen plotter apparatus, according with an aspect of the present invention.

FIG. 12 is a flow diagram illustrating a method of forming DER patterns on strap and/or inlay substrates using a DER ink printing technique, in accordance with an aspect of the present invention.

FIG. 13 is a top view drawing of a web of strap substrates following performance of the DER printing method shown in FIG. 12.

FIG. 14 is a top view drawing of a portion of an inlay substrate roll following performance of the DER printing method shown in FIG. 12.

FIG. 15 is a flow diagram illustrating a strap preparation process, in accordance with an aspect of the present invention.

FIG. 16 is a top view drawing of a strip containing a plurality of straps following the web-cutting step in the strap preparation process shown in FIG. 15.

FIG. 17 is a perspective view drawing of a strip containing a plurality of straps following a DER edge-dipping step in the strap preparation process shown in FIG. 15.

FIG. 18 is a top view drawing of a DER edge treated strap following the DER edge dipping and strap cutting steps in the strap preparation process shown in FIG. 15.

FIG. 19 is a flow diagram illustrating a strap mounting process for assembling the DER edge treated straps in FIG. 18 onto the inlay substrates of the inlay roll in FIG. 14, according to an aspect of the present invention.

FIG. 20 is a top perspective view drawing illustrating the mounting of a strap onto an inlay substrate, according to an aspect of the present invention.

FIG. 21 is a flow diagram illustrating an electroplating process and various label lamination techniques, in accordance with aspects of the present invention.

FIG. 22 is a cross-sectional drawing of an exemplary RFID label manufactured in accordance with the methods of the present invention.

FIG. 23 is a cross-sectional drawing of an RFID inlay structure, according to an alternative embodiment of the present invention.

FIG. 24A-C are cross-sectional, top and perspective view drawings, respectively, of a strap with DER strap pad extension patterns for the RFID inlay structure shown in FIG. 23.

FIG. 25 shows a perspective drawing of a plurality of RFID inlay structures, according to an embodiment of the present invention.

FIG. 26 is a drawing of a test/inspection apparatus, according to an embodiment of the present invention.

FIG. 27. is a top view drawing of an exemplary sheet of RFID inlays containing different RFID tag types that can be tested using the test/inspection apparatus shown in FIG. 26.

### DETAILED DESCRIPTION

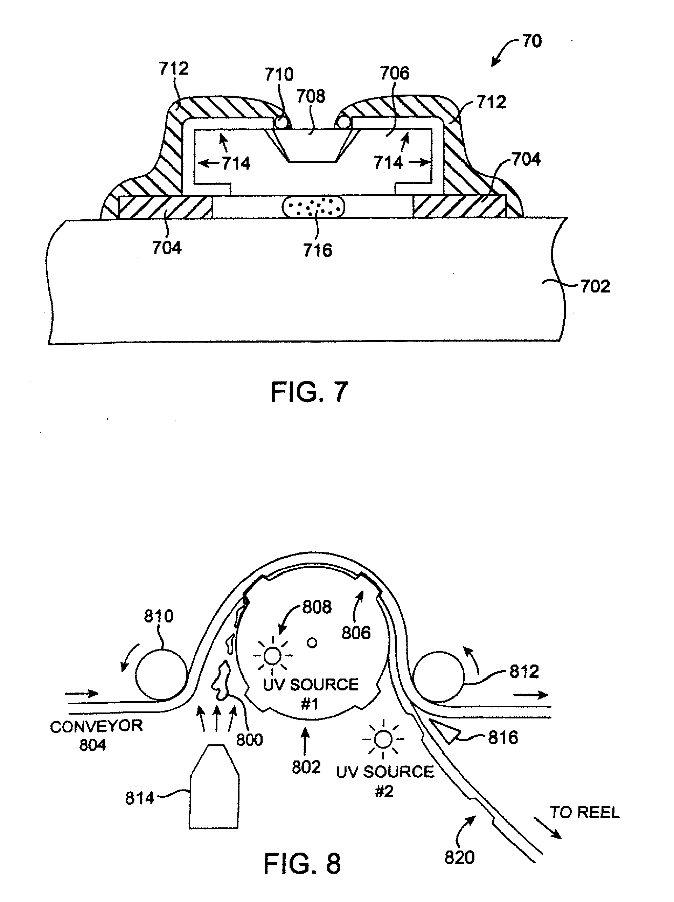

Referring to FIG. 7, there is shown a cross-sectional diagram of an RFID inlay structure 70, according to an embodiment of the present invention. The RFID inlay structure 70 comprises an inlay substrate (i.e. antenna substrate) 702, upon which an antenna having antenna contacts 704 are formed; a strap substrate 706; and an RFID chip 708. Conductive bumps (or other chip contacts) 710 of the RFID chip 708 are electrically connected to the antenna contacts 704 by way of an electroplated metal layer 712 formed over a layer of directly electroplateable resin (DER) 714. Edges of the strap substrate 706 may also be coated with a DER layer, which as explained in more detail below helps to ensure that the electroplating layer 712, when formed, forms a continuous electrical connection between the antenna contacts 704 and the chip contacts 710. A pressure sensitive adhesive (PSA) 816 or other suitable adhesive may also be applied between the strap substrate 706 and the inlay substrate 702. The PSA 816 prevents movement of the strap during the electroplating process.

The inlay substrate 702 may be formed from various polymeric materials, e.g., polyethylene, or may be formed from paper, laminations of paper and a polymeric film. Further, the inlay substrate 702 may be rigid or flexible. If flexible, a plurality of antennas formed on a single long roll of substrates may be conveniently wound on a reel. The plurality of antennas and corresponding antenna contacts 704 may be formed from a conductive ink, DER (e.g. when the strap pad patterns are patterned using DER), electroplating, deposition or sputtering methods (e.g. vapor deposition), conventional etching techniques, or other suitable method. If the strap pad patterns, antennas and corresponding contacts 704 are formed using DER, the DER used to print the antennas and corresponding antenna contacts 704 is formulated so that it is compatible with the DER formula used to form the strap pad patterns. This helps to ensure that even plating occurs during the electroplating process.

The strap substrate 706 may be formed using conventional embossing methods such as, for example, those describe above. Alternatively, and as shown in FIG. 8, a plurality of straps may be formed using a casting technique, according to an embodiment of the present invention. According to this technique, a low viscosity material (e.g. a UV curable acrylate epoxy or low-shrinkage polymer ((UV curable or non-UV curable) that can be cast in liquid form) 800 is injected between a casting drum 802 and a conveyor belt 804. The casting drum 802 has a plurality of casting patterns 806 around the drum's circumference, and a first ultraviolet source 808 in its interior. Rollers 810 and 812 continuously convey the conveyor belt 804 around the casting drum 802 while the low viscosity material 800 is injected from an injector 814 between the drum surface and the bottom surface of the conveyor belt 804. The first ultraviolet source 808 operates to partially cure the low viscosity material 800 as the casting drum 802 turns. A separator 816 separates the semi-cured material, as a second ultraviolet source 818 cures the material to its final form.

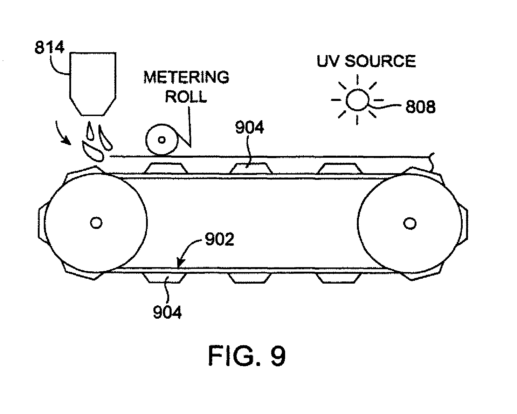

Rather than using a casting drum 802, as in FIG. 8, according to an alternative embodiment of the invention, an endless belt 902, as shown in FIG. 9, having casting patterns 904 may be employed to forma plurality of straps. An advantage of this approach is that the casted patterns are formed on a flat surface, and therefore a better representation of the desired features may be obtained than can be achieved with a casting drum.

The above casting techniques are suitable for reel-to-reel processing, whereby the finished web may be rolled onto a reel for easy storage and transport to further processing and assembly stations. In some applications, however, rigid flat sheets of substrates may be preferable. In such circumstances, a glass plate (e.g. 18" x 24") having etched patterns may be used and the low-viscosity material may be cast over it using, for example, a drawdown coater. In this manner, very thin, yet rigid substrates can be created.

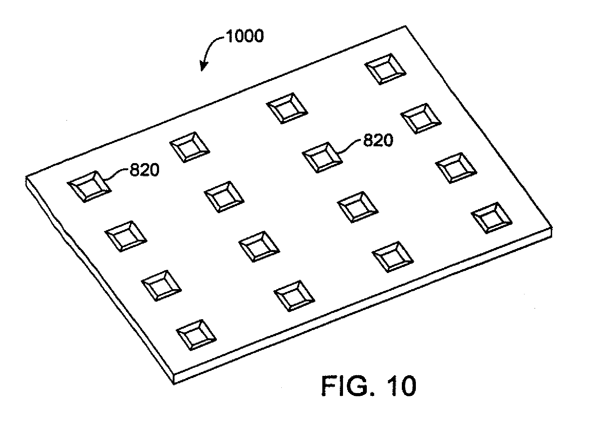

As illustrated in FIG. 10, the resulting substrate sheet (or "web") 1000, as produced from one of the casting or drawdown techniques described above, contains a plurality of recessed regions 820 formed by the casting process. The recessed regions 820 are used to accommodate RFID chips 708 placed, for example, using a fluidic or vibration assembly process. The cured substrate sheet may be stored in roll form by winding the finished product on a reel. Depending on manufacturing requirements, different drums having different casting patterns 806 may be employed to cast recessed regions 820 having different dimensions (e.g. to accommodate RFID chips of different sizes; or to vary recess-to-recess spacing). Further, unlike the embossing methods used in the prior art, the thickness of the substrate sheet can be easily changed and controlled, depending on the application. Further, unlike embossing, the material is not stressed to create the recessed regions 820, and the recessed regions 820 retain their dimensional characteristics much better than recessed regions formed by embossing methods.

Following is a description of an exemplary method of manufacturing the RFID inlay structure 70 in FIG. 7, according to an embodiment of the present invention. A first step in the method is that of providing a substrate, web or sheet 1000, for example similar to that shown in FIG. 10, having a plurality of recessed regions 820 sufficient in size to accommodate the RFID chips 708. Next, the RFID chips 708 are assembled into the recessed regions 820 of the web using a fluidic self assembly (FSA) process, as described for example in U.S. Patent No. 5,545,291. According to the FSA technique, the RFID chips 708, which have been preformed with beveled edges (as previously described) are mixed in a fluid (e.g. water, acetone and/or alcohol) to form a slurry. The slurry is flowed over the top surface of the web, whereupon the chips fall and self-align into the recessed regions 820. Other assembly methods besides FSA may be used. For example, vibration self-assembly, whereby the RFID chips are vibrated over the web surface until the RFID chips self-align into the recessed regions 820, may also be used.

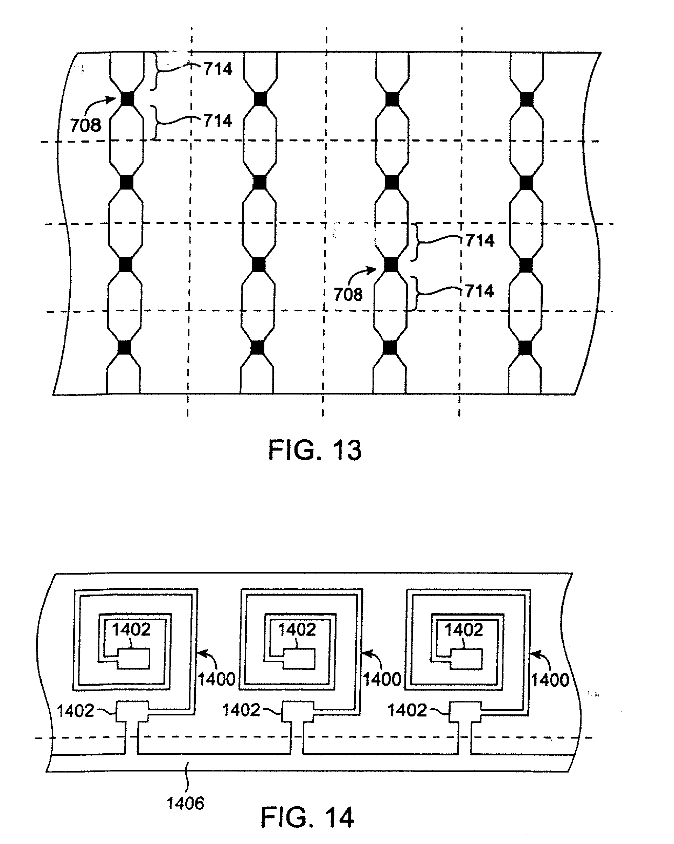

Next, directly electroplateable resin (DER) strap pad patterns 714 are formed on the upper surface and, optionally, edges (including a portion of the bottom surface along the edges) of the strap substrate. (See FIG. 7.) One or more plating bus bars may also be printed on the strap substrate with DER (similar to that shown in FIG. 14 below for the antenna substrate), depending on the application. The bus bars serve as electrical terminals which the electroplating equipment can connect to during the electroplating process. The DER material comprises a binder (i.e. resin) or co-binder and at least one conductive powder having a mean particle size of 2 microns or less. The conductive powder may contain carbon black and/or graphite in the amount sufficient to produce a "microscopic" electrical volume resistivity of less than 1000 ohm-cm (e.g., less than 100, 10 or 1 ohm-cm). Optionally, a presence of sulfur, in amounts greater than about 0.1 % by weight of the overall composition, may be added.

Use of DER materials is desirable since they do not require any pretreatment prior to being electroplated. They can also be applied very rapidly, and require no electrical bonding operations. These attributes make DER materials well suited for the manufacture of RFID inlays.

According to an embodiment of the invention, the DER material may be formulated to produce a low viscosity DER solution or DER "ink" (not to be confused with prior art non-DER inks). The DER ink may comprise, for example an evaporating solvent and a heat curing catalyst, such that when the solvent evaporates, the DER coating remains uncured and has flow properties that allow setting of the RFID chip. Once heat is applied to the assembly, the polymer hardens and the chip is secured. By properly adjusting and controlling the viscosity of the DER ink, a plotter pen of a conventional plotter apparatus may be used to form the DER patterns. Application by a plotter pen further shortens the time required to form the DER patterns, is more precise than techniques used in the prior art, and, consequently, results in lower manufacturing and assembly costs.

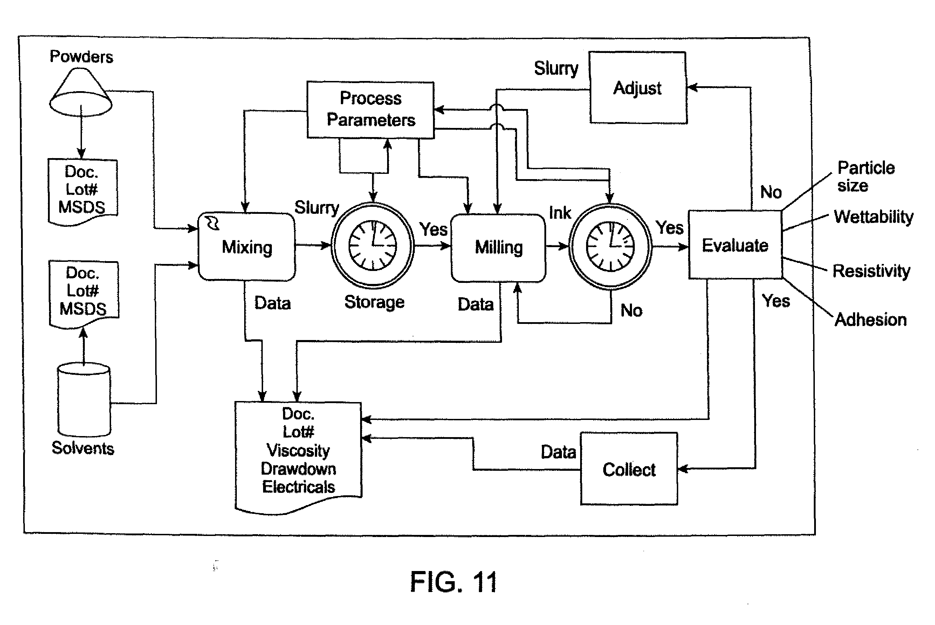

FIG. 11 is a flow diagram illustrating the manufacture of a DER ink, including that suitable for application by a pen of a conventional pen-plotter apparatus, according to an aspect of the present invention. The basic formulation for the DER is that described in U.S. Patent No. 6,582,887 to Luch. The binder and carriers solvent (if any) are measured and mixed using known methods. Powders and additives are mixed to the binder/carrier solution following methodology known in the field, to optimize dispersion and particle size distribution forming a slurry. Appropriate amounts of materials such as graphite, aluminum powders, oxides, etc. may also be added to serve as a lubricants or cleaners to aid the performance of the pen. The resulting slurry may be milled, if necessary, to further reduce the particle size and/or optimize dispersion necessary for proper performance of the pen of the pen-plotter apparatus. One or more of the particle size, wettability, resistivity, and adhesion characteristics after milling are then measured to characterize the ink. Once the ink meets the required specifications, it is collected and stored. Based on the measurements, additional carbon black, sulfur, graphite, and/or solvent are added to the ink (or "slurry"), and further milling is performed if necessary to achieve the desired DER ink characteristics.

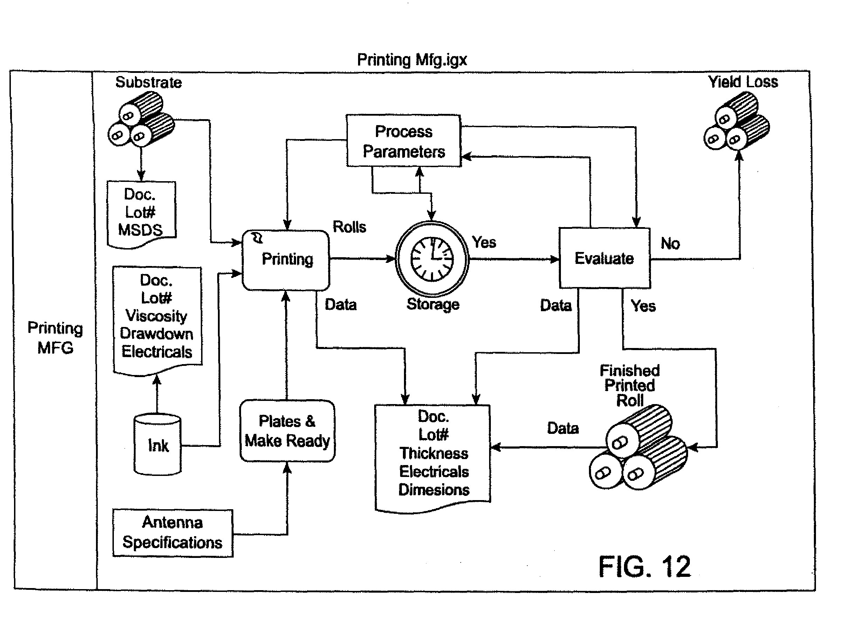

Figure 12 is a flow diagram illustrating an exemplary method of forming DER patterns using a DER ink printing technique, according to an embodiment of the invention. As explained next, the DER printing technique describe herein may be used to print strap pad patterns 714 or loop antenna patterns on strap substrates 706, and may also be used to print antenna features and antenna contact patterns on the inlay substrate 702.

To print strap pad patterns 714, a sheet or roll of strap substrate material is first provided. The sheet or roll of strap substrate material is preferably in the form of a web of strap substrates having a plurality of casted recessed regions 820 with corresponding RFID chips 708. Based on predetermined process parameters and configuration of the particular strap type, the web or sheet is properly configured and secured for printing. A DER ink supply, for example as manufactured in accordance with the DER ink manufacturing process shown in FIG. 11, is configured for application by the printing tool (e.g. pen-plotter apparatus). Process parameters are provided to the printing tool. Next, the printing process is performed to form the DER strap pads patterns 714 (on the strap substrate 706). After printing, the printed strap substrate sheets are stored and subsequently transferred to an evaluation station, where each of the strap substrates 706 of the strap substrate sheet is evaluated to determine whether the intended characteristics (pattern dimensions, thickness, electrical characteristics, etc.) have been achieved.

FIG. 13 shows a top view of a web of strap substrates (outlined by dashed lines) following the printing process of FIG. 12. As shown, each of the recessed regions contains an RFID chip 708. DER strap pad patterns 714 have been printed over a portion of the strap substrates as shown, and in contact with the chip contacts of each of the RFID chips 708. The DER strap pad patterns 714 are used later in the RFID inlay manufacturing process to electroplate an electrically conductive interconnect between the chip contacts of the RFID chips 708 and the antenna contacts formed on the inlay substrate.

The DER printing technique in FIG. 12 may also be employed to print DER antenna features, antenna contact patterns, and plating bars on the inlay substrate, and is particularly applicable when the strap pad patterns on the strap substrates of the web or sheet of straps have been formed using DER. The process is similar to that described to print the strap pad patterns. FIG. 14 shows a top view of a portion of the inlay substrate roll following the printing process. As shown, a plurality of DER antenna patterns 1400, with associated DER antenna contact patterns 1402, and a plating bus bar 1406 have been formed on the inlay roll. The plating bar 1406 is used to apply a voltage to the RFID inlay structure 80 during an electroplating process. After electroplating, the plating bar may be separated from the inlay antenna by, for example, laser cutting the metal interconnects between the antenna feature and the plating bar (e.g. along the dashed line in FIG. 14).

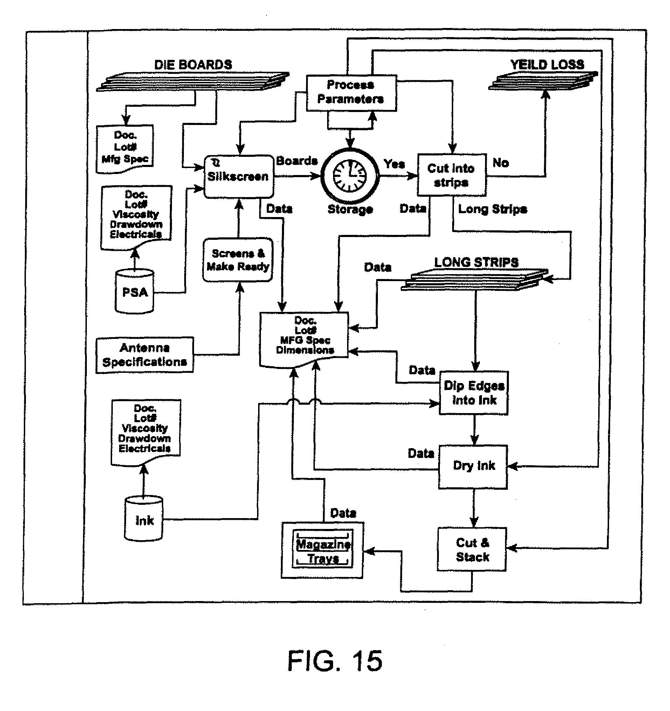

FIG. 15 shows an exemplary flow diagram illustrating a strap preparation process, whereby a pressure sensitive adhesive (PSA) strip (or PSA drops) or other suitable adhesive material is formed on the undersides of the strap substrates, and the printed web is separated into individual straps. As shown, the printed web (referred to as "die boards" in the drawing) containing the plurality of RFID chips is laid flat so that the backside of the web is accessible for a silkscreen process. Once properly configured, an electrically non-conductive PSA having suitable viscosity, electrical and drawdown characteristics is provided for application by a silkscreen tool or other application method available in the art. The silkscreen process applies a line or drops of PSA strips on the backsides and along the lengths of each of the strap substrates of the web. (In an alternative embodiment, the PSA drops may be formed at appropriate positions on the inlay substrates, in preparation of attaching the straps to the inlay substrate.)

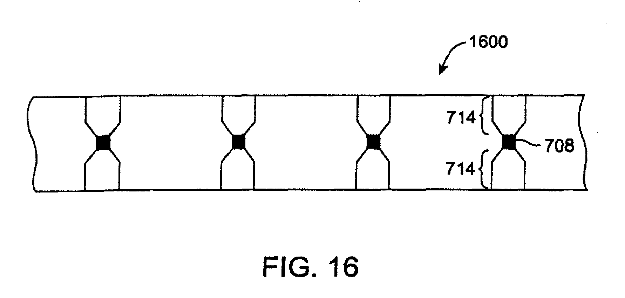

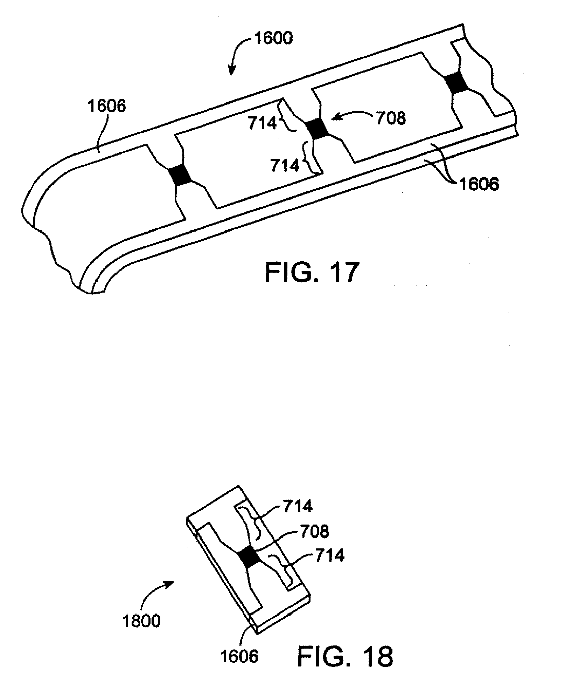

After the PSA has been applied, the web is stored and subsequently transferred to an evaluation station to determine whether the PSA application has been properly performed. If major faults are detected, the web or faulty portion thereof is scrapped. If all tests pass, the web is then cut into long strips 1600, as shown in FIG. 16. Each strip 1600 contains a single row of RFID chips, DER strap pad patterns 714, and optionally, a PSA strip extending along the length and centerline on the underneath side of the long strip 1600. After the long strips 1600 have been formed, the longitudinal edges of each long strip 1600, and portions of the top surfaces of each RFID chip 708 adjacent to the RFID chip's contacts (if necessary), are dipped in DER ink and allowed to dry. The result of the dipping process, including the DER treated edges 1606, is shown in FIG. 17. The DER edge-treated strips 1600 are then cut into individual straps and stored in a magazine type applicator for subsequent processing. A top view of a DER edge treated strap 1800 after the cutting step is shown in FIG. 18. In an alternative embodiment, one or more of the strips may be rolled onto a reel and subsequently sold to customers or subsequently retrieved to complete the manufacture of the RFID inlays.

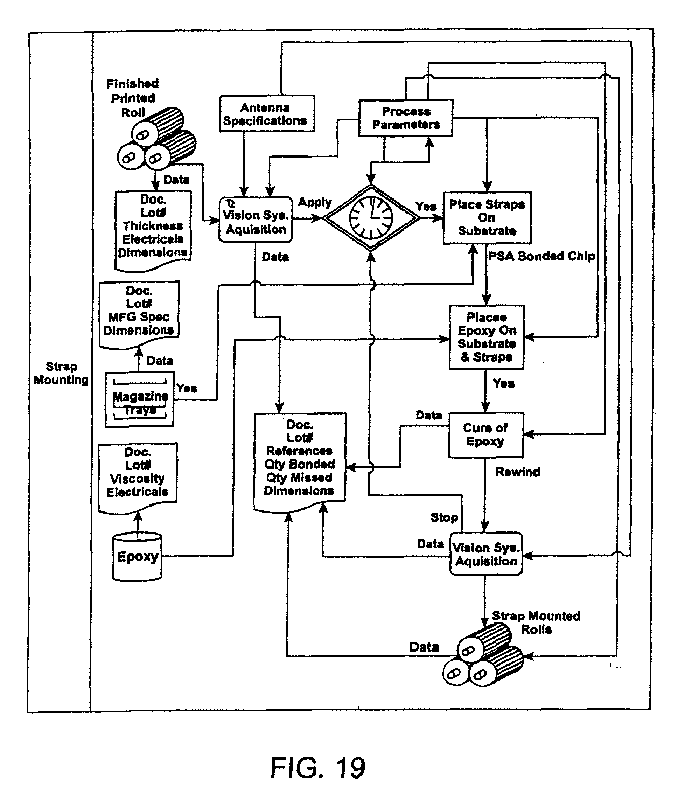

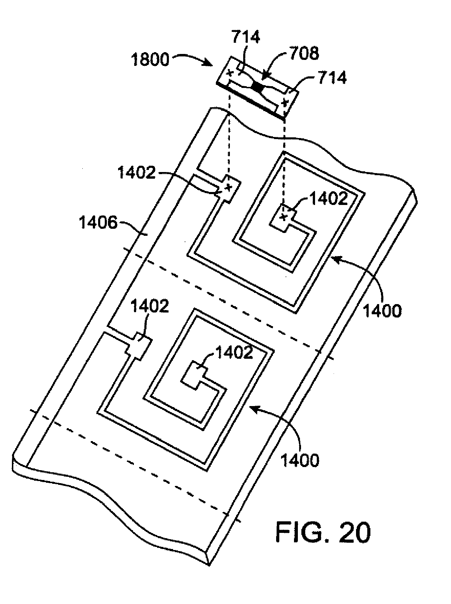

Referring next to FIG. 19, there is shown a flow diagram illustrating a strap mounting process for assembling the DER edge treated straps onto the inlay substrates of the inlay roll (see FIG. 14), according to an embodiment of the present invention. In preparation of the strap mounting process, a finished roll of inlay substrates (e.g. as obtained from the DER printing method described in connection with FIG. 13 above) is provided. With the aid of a machine vision system, and in accordance with a pick and place process, the DER strap pad patterns of a strap are aligned with the antenna contact patterns of an inlay substrate on the inlay roll and, once aligned, the strap is temporarily secured to the inlay substrate by the PSA that was applied to the backside of the strap during the strap preparation method described above (see FIG. 15 and accompanying description). A top perspective view of the aligning and mounting process is shown in FIG. 20.

According to an aspect of the invention, the machine vision system may be adapted to determine the shape of the antenna, antenna contact patterns, or other shape or indicator, on the inlay substrate. Based on the identified shape or indicator, the pick and place process may be programmed to select from among different types of strap substrates. In this manner, different types of RFID inlays can be manufactured in the same process flow without requiring human intervention.

After the straps 1800 have been mounted to the roll of inlay substrates, small drops of epoxy may then be applied between the RFID chips 708 and strap substrates. After mounting, the strap pad patterns 714, antenna contact patterns 1402, antenna features 1400, and plating bar 1406 are all in electrical contact and ready for electroplating. The finished strap-mounted inlays are then rolled onto a reel and transferred to a plating station. Alternatively, the finished strap-mounted inlays are run to an electroplating station in a continuous process.

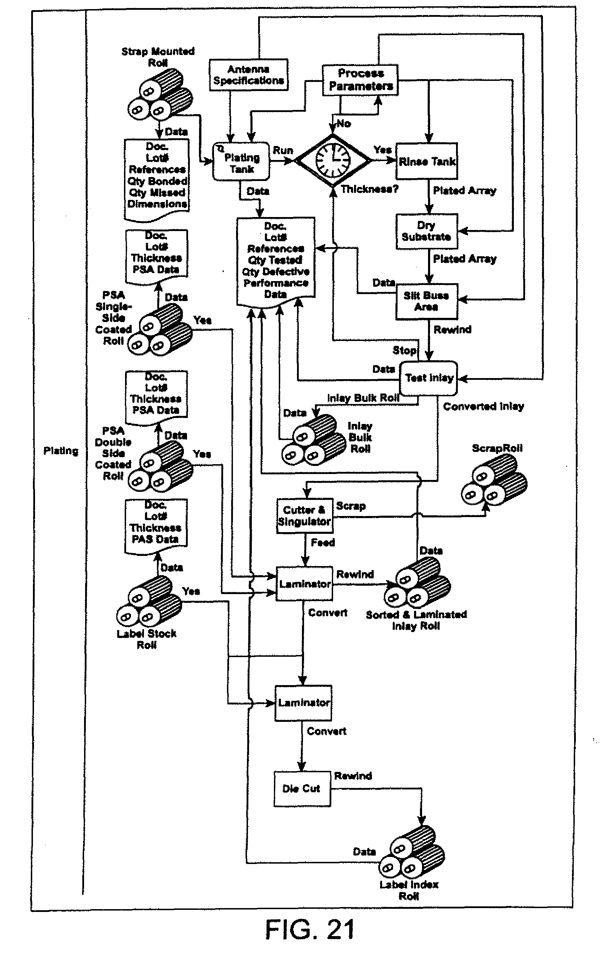

FIG. 21 shows a flow diagram illustrating an electroplating process performed to complete the final RFID inlay shown in FIG. 7. In preparation of the plating process, a roll of finished strap-mounted inlays is configured for passing through a plating bath. The plating bath may be of the composition used to electroplate nickel (e.g. a nickel chloride salt) or other composition for depositing other types of metals (e.g. gold, silver, copper, etc.). In preparation, a power supply is also configured to supply the appropriate electrical charge to the plating bar. Once the roll and power supply are properly configured, the roll of strap-mounted inlays are passed through the plating bath. During the process, all DER coated surfaces (and metal coated surfaces, e.g. the RFID chip contacts are plated. Once plated, seamless electrical interconnections between the antenna contacts on the inlay substrate and the contacts of the RFID chips are present. No secondary operations related to the interconnections (e.g. a conductive epoxy, as is needed in the prior art) are required once the components are mounted and plated.

After plating, the finished RFID inlay roll is rinsed and allowed to dry. Then the plating bar is slit, for example using a laser cutter, so that the plating bar is no longer in electrical contact with the antenna on the inlay substrates. Finally, the finished RFID inlays are inspected to ensure that the plating process has been properly completed. Defective inlays are marked, separated and scrapped. Those RFID inlays that pass inspection are separated and sent to a laminator to form RFID labels.

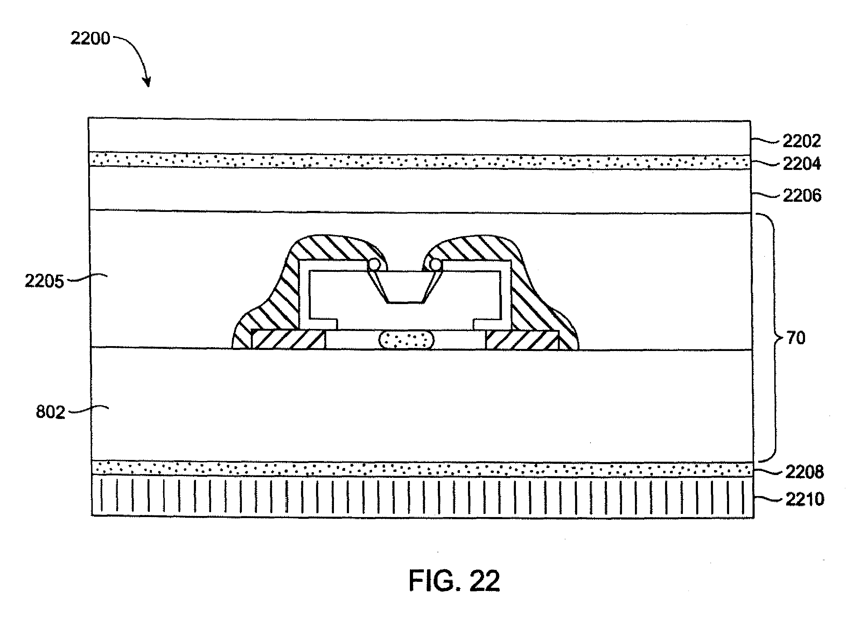

In addition to the electroplating operation just described, FIG. 21 shows various laminating methods that can be performed on the completed RFID inlays, to form RFID labels. The laminating method selected depends on the requirements of the finished label. The separated RFID inlays may be formed on a label substrate having a single PSA coating, formed on a label substrate having a double-sided PSA coating, or formed on a substrate not having a PSA coating. After the labels have been formed, they may be wound on a reel in roll form for subsequent shipping to customers. An exemplary finished RFID label 2200 is shown in FIG. 22. A filler layer 2205, e.g., comprised of a PSA material is formed over the electroplated surface of the RFID inlay 70 to protect the RFID inlay 70 and to provide a planar surface upon which other label layers may be formed. A lamination substrate 2206 is formed over the filler layer 2005. A printable substrate 2202 is formed over the lamination substrate 2206 and secured to the lamination substrate 2206 by an adhesive (e.g. PSA) layer 2204. The opposing side of the RFID inlay 70 may be secured to a release carrier 2210 by means of a second adhesive (e.g. PSA) layer 2208.

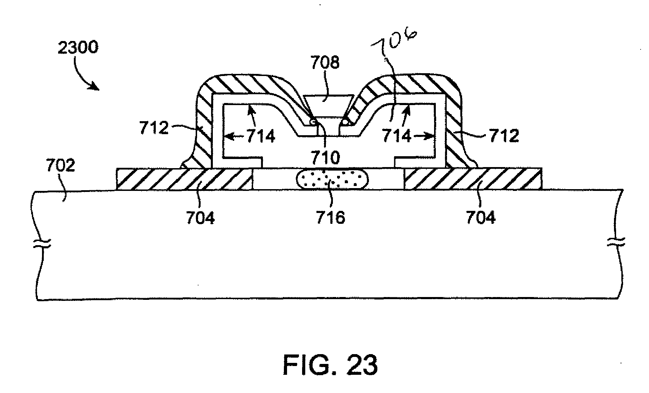

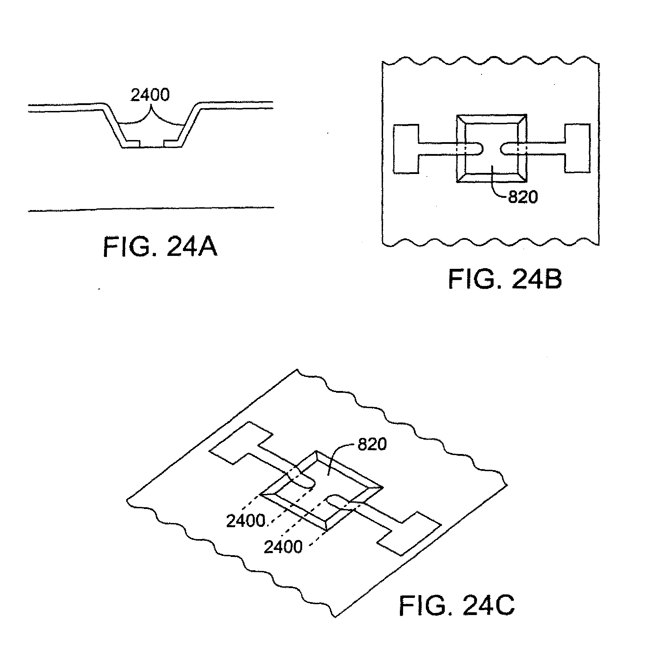

FIG. 23 shows a cross-sectional drawing of an RFID inlay structure 2300, according to an alternative embodiment of the present invention. According to this embodiment, the RFID chip contacts 710 are placed in the recessed region so that the chip contacts 710 face the bottom of the recessed region, similar to a flip-chip mounting technique used in the semiconductor industry. To facilitate the formation of electrical interconnections between the chip contacts 710 and antenna contacts 704, a strap substrate 706 having a DER pattern like that shown in FIGS. 24A-C may be used. Compared to the DER strap pad patterns 714 of the finished strap substrate roll in FIG. 13, the DER pattern in FIG. 24 includes strap pad extensions 2400 that extend to the bottom of the recessed regions 820. Because the DER strap pad patterns 714 are formed on the bottoms of the recessed regions, DER printing is performed prior to assembling the RFID chips 708 into the recessed regions 820. Although not shown in the FIG. 24, the strap pad extensions 2400 may each be configured of an appropriate geometry that guarantees proper electrical contact to the chip contacts 710 regardless of how the chip contacts are oriented as they are assembled into the recessed regions 820. Other details concerning the printing, strap preparation, mounting, and electroplating processes are similar to those described above for manufacturing the RFID inlay 70 in FIG. 7 may be employed to complete the manufacture of the RFID inlay structure 2300 shown in FIG. 23.

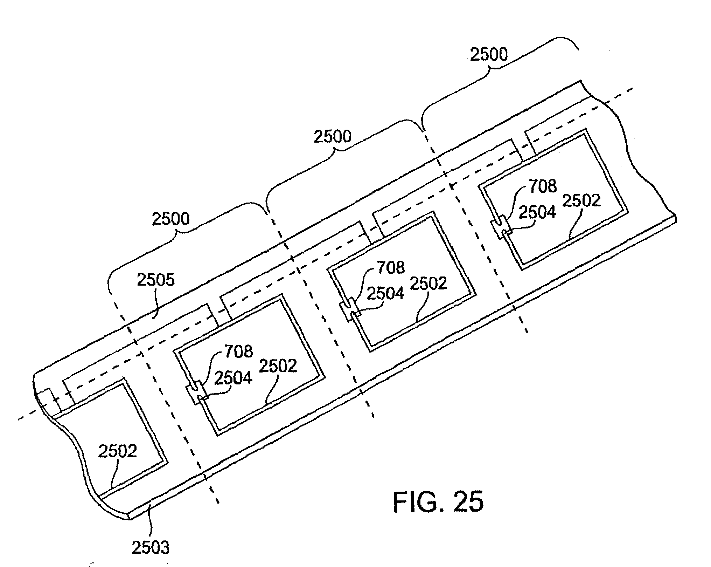

FIG. 25 shows a perspective drawing of a plurality of RFID inlay structures 2500, according to an embodiment of the present invention. According to this embodiment of the invention, DER antenna loop patterns 2502 are formed on the same substrate 2503 that the RFID chips 708 are mounted. The RFID chips are mounted to the substrate 2503 prior to forming the DER antenna loop patterns 2502. Then, by using a plotter pen type device and a DER ink (similar to that described above), the antenna loop patterns 2502 are formed. The DER ink is also applied onto the RFID chip contacts 2504. One or more bus bars 2505 are also formed on the substrate 2503 using the DER ink to provide bus bar connections during an electroplating process. Similar to that explained above, the bus bar 2505 is separated from the antenna loops after the electroplating process. While each of the RFID inlay structures 2500 are shown to have only a single loop, those of ordinary skill in the art will readily appreciate and understand that multiple loops may be formed. For example, by forming DER coated vias through the substrate 2503, additional loops can be formed on the opposite side of the substrate 2503. After the electroplating process, the RFID inlay structures 2500 may be cut into individual inlays and formed into RFID labels, similar to that described above.

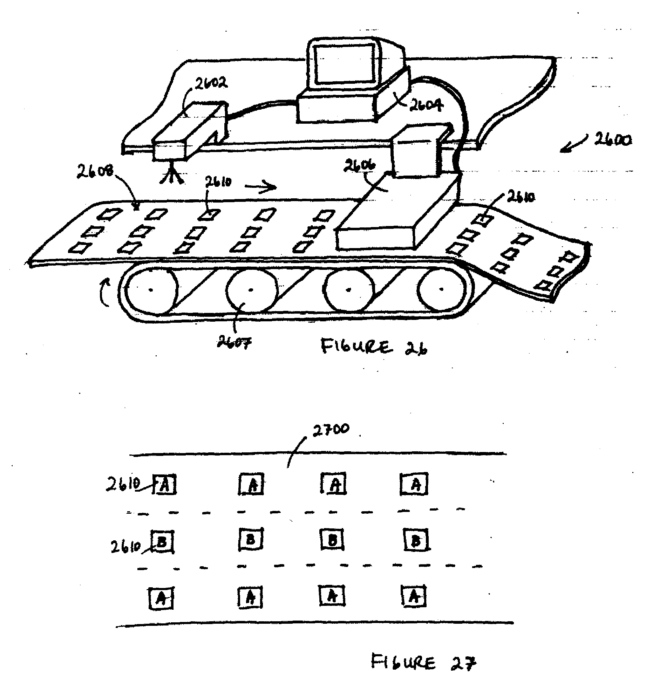

As explained above, the finished RFID inlays of the present invention are inspected at various stages of their manufacture. For example, following the electroplating process described in reference to Figure 21, an inspection of the RFID inlays is performed. FIG. 26 is a simplified drawing of an inspection apparatus 2600, which may be used to inspect a strip, sheet, web or roll containing a plurality of RFID inlays, according to an embodiment of the present invention. Preferably, the inspection apparatus 2600 is employed following the electroplating process described above (or other similar electroplating process), in a continuous manufacture/inspection operation; additionally or alternatively, the inspection apparatus 2600 may be employed at other stages and/or times in the manufacturing process.

The inspection apparatus 2600 in FIG. 26 comprises an RFID reader 2602, a computer or workstation 2604, a printer (e.g. an ink jet printer) 2606 or labeling apparatus, and a transport apparatus (e.g. a conveyor) 2607. The RFID reader 2602 and the printer 2606 are connected to the computer/workstation 2604 by standard interfaces (e.g. serial, parallel, USB, RS-232, etc.). The RFID reader 2602 may comprise a single-mode reader, which is operable to read RFID inlays incorporating RFID chips of the same type. Alternatively, the reader 2602 may comprise a multi-mode reader or a multi-protocol reader configured to read RFID inlays incorporating different types of RFID chips. In the context of the invention, the terms "different types of RFID chips" or "different RFID chip types" are meant to include, but are not limited to, two or more RFID chips having one or more of the following distinguishing characteristics: size, shape, modulation protocol, encoding protocol, modulation frequency (e.g., low-frequency (LF) 125-135 kHz, high-frequency (HF) 13.56 MHz, ultra-high-frequency (UHF) 860-960 MHz, 3.45 GHz, 5.8 GHz, or other frequencies or frequency bands), class (e.g. Class 0, 1, etc.), generation (e.g. Gen. 1, 2, etc.), passive, active, backscatter, SAW (surface acoustic wave) based, CMOS-based, Title 21, read/write, read only, WORM (write once read many), and rewritable.

As shown in FIG. 26, a strip, sheet or web 2608 of RFID inlays (or, alternatively a roll of RFID inlays) 2610 incorporating RFID chips is fed into the inspection apparatus 2600 by the conveyor 2607 or other suitable transport mechanism. As the RFID inlays 2610 of the strip, sheet, web or roll are moved through the apparatus, the RFID reader 2602 reads the RFID chips incorporated in the RFID inlays 2610. Each RFID chip of each RFID inlay 2610 is read and tested for functionality, frequency, transmission and reception capabilities, noise susceptibility, etc. The test/inspection measurements are collected and transmitted to the computer/workstation 2604 for processing and to determine whether the RFID chips of the respective RFID inlays 2610 are within predetermined and acceptable limits or satisfy other predetermined specifications.

According to an embodiment of the invention, the serial numbers or other information stored in the RFID chips of those RFID inlays passing inspection are read by the reader 2602 and transmitted, via the computer/workstation 2604, to the printer 2606. The printer responds by printing the RFID inlays passing inspection with the serial numbers of the inlays' associated RFID chips, or other information (e.g. customer information, manufacture information, etc.). Alternatively, or additionally, those RFID inlays containing RFID chips determined to be faulty or not in compliance with the predetermined test/inspection limits or specifications may be labeled as defective.

As explained above, the strip, sheet, web or roll of RFID inlays 2610 fed into the inspection apparatus 2600 may contain RFID inlays incorporating RFID chips of the same type or, alternatively, may contain RFID inlays incorporating RFID chips of different types. FIG. 27 is a top view drawing of an exemplary sheet 2700 of RFID inlays 2610 which can be inspected using the inspection apparatus 2600. The plurality of RFID inlays 2610 formed on the sheet 2700 incorporate different types of RFID chips. The labels "A" and "B" indicate that the sheet 2700 includes RFID inlays incorporating chips of type "A" or "B", and are used generically to indicate any distinguishing characteristic. Some exemplary distinguishing characteristics which distinguish between a type A and type B chips types are described above.

The manufacturing of the strips, sheets, webs or rolls of RFID inlays 2610 containing different RFID chip types may be manufactured according to the DER-based manufacturing methods described above. For example, to manufacture strips, sheets, webs or rolls of RFID inlays 2610 containing two or more different types of RFID chips, different chip-type specific, manufacturer or customer specific process parameters are provided to the DER printing tool. (See description of DER printing above.) The DER printing tool responds to the specified parameters to form the DER strap pad patterns on the strap substrates and/or the antenna patterns on the inlay substrates which are necessary to accommodate the different RFID chip types. Similarly, different chip-type specific, manufacturer, or customer specific process parameters are provided to the machine vision system, so that different strap substrates possibly carrying different RFID chip types may be properly positioned on corresponding RFID inlay substrates. It should be mentioned here, that while preferred embodiments of the inspection apparatus and methods of the present invention involve inspecting RFID inlays manufactured using the DER and electroplating techniques described above, those of ordinary skill in the art will readily appreciate and understand that other manufacturing methods not utilizing DER and/or not utilizing electroplating techniques are within the spirit and scope of the present invention. Accordingly, the inspection apparatus and inspection methods of the present invention should be viewed as extending to inspecting strips, sheets, webs or rolls of RFID inlays incorporating different RFID chip types that have been manufactured with or without DER application and/or with or without the electroplating methods described above.

According to an exemplary embodiment of the invention, the multi-mode reader 2602 comprises the multi-protocol XCI-DMU2 (Detector Module Unit) reader, which is commercially available reader available from XCI Incorporated, San Jose, CA. Other types of multi-protocol or multi-mode readers may also be used. For example, any one of the multi-mode readers disclosed and/or claimed in commonly assigned U.S. Patent Nos. 6,107,910, 6,433,671, 6,531,957, 6,580,358, 6,950,009 and U.S. Patent Application No. 10/901,743, which are hereby incorporated into the present disclosure by reference, may be used. It should be mentioned here that, for the purposes of this disclosure, including the claims attached hereto, the terms "multi-mode reader" and "multi-protocol reader" are both meant to include within their meaning any RFID reader that is capable of reading two or more different types of RFID chips.

While particular embodiments of the present invention have been shown and described, it will be obvious to those skilled in the art that, based upon the teachings herein, changes and modifications may be made without departing from this invention and its broader aspects. Further, whereas the preferred embodiments have been described in terms of RFID integrated circuits, and using DER printing techniques to form the electrical interconnections between the RFID chip contacts and an antenna, the methods and apparatus of the present invention are applicable to other types of integrated circuits and electronic components that requires electrical connections between their terminals and contacts of other electrical components. Therefore, the appended claims are intended to encompass within their scope all such changes and modifications as are within the true spirit and scope of this invention.

## Claims

1. A method of manufacturing an RFID inlay, comprising:
providing a strap substrate containing an RFID chip;
forming electrically conducting strap pad patterns that cover a portion of a first major surface of said strap substrate and electrical contacts of said RFID chip;
providing an inlay substrate having an electrically conductive antenna and antenna contact patterns; and
electroplating said strap pad patterns and said antenna contact patterns to form metal strap pads, metal antenna contacts, and a metal interconnect between said antenna contact patterns and said electrical contacts of said RFID chip.

2. The method of manufacturing an RFID inlay according to Claim 1 wherein forming electrically conducting strap pad patterns comprises forming electrically conductive strap pad patterns from a directly electroplateable resin (DER).

3. The method of manufacturing an RFID inlay according to Claim 2, further comprising coating one or more edges of the strap substrate with a DER.

4. The method of manufacturing an RFID inlay according to Claim 2, further comprising forming the antenna contact patterns from DER.

5. The method of manufacturing an RFID inlay according to Claim 2 wherein forming electrically conductive strap pad patterns from a DER comprises printing the DER on the strap substrate.

6. The method of manufacturing an RFID inlay according to Claim 2 wherein forming electrically conductive strap pad patterns from a DER comprises applying the DER by a plotter pen apparatus.

7. The method of manufacturing an RFID inlay according to Claim 1, further comprising assembling the RFID chip into a recessed region of the strap substrate prior to forming the DER strap pad patterns.

8. The method of manufacturing an RFID inlay according to Claim 1 wherein providing a strap substrate comprises:
casting a web of strap substrates from a low viscosity material, said web including a plurality of recessed regions;
assembling a plurality of RFID chips into the plurality of recessed regions; and
cutting the web of strap substrates into a plurality of strap substrates to provide said strap substrate having a recessed region containing an RFID chip.

9. The method of manufacturing an RFID inlay according to Claim 8 wherein assembling a plurality of RFID chips in the plurality of recessed regions is performed by a self-assembly process.

10. The method of manufacturing an RFID inlay according to Claim 9 wherein the self-assembly process comprises a fluidic or vibration self-assembly process.

11. The method of manufacturing an RFID inlay according to Claim 1 wherein the DER is formulated from a binder and a conductive powder.

12. The method of manufacturing an RFID inlay according to Claim 11 wherein the DER has a microscopic electrical volume resistivity of less than about 1000 ohm-cm.

13. The method of manufacturing an RFID inlay according to Claim 11 wherein the conductive powder has a mean particle size of less than about two microns.

14. The method of manufacturing an RFID inlay according to Claim 1 wherein the metal strap pads and metal interconnect are formed during a single electroplating process.

15. The method of manufacturing an RFID inlay according to Claim 1 wherein providing a strap substrate comprises:
providing a web of strap substrates, said web having a plurality of recessed regions; and
assembling a plurality of RFID chips into the plurality of recessed regions.

16. The method of manufacturing an RFID inlay according to Claim 15, further comprising separating said web into a plurality of strips, each strip having a succession of strap substrates and corresponding RFID chips

17. The method of manufacturing an RFID inlay according to Claim 16 wherein said strap pad patterns are formed prior to separating the web into a plurality of strips.

18. The method of manufacturing an RFID inlay according to Claim 15 wherein assembling the plurality of RFID chips into the plurality of recessed regions is performed using a self-assembly process.

19. The method of manufacturing an RFID inlay according to Claim 2, further comprising, prior to providing a strap substrate containing an RFID chip,
forming a recessed region in said strap substrate;
forming DER strap pad pattern extensions that extend into said recessed region; and
assembling the RFID chip into said recessed region so that the RFID chip contacts are in electrical connection with the strap pad pattern extensions.

20. A method of manufacturing strap substrates for an RFID inlay, comprising:
providing a substrate;
placing a plurality of RFID chips onto said substrate; and
forming strap pad patterns or antenna coil patterns of directly electroplateable resin (DER) on said substrate, at least one of said DER strap pad patterns or DER antenna coil patterns having a terminal that is in electrical contact with an electrical contact of an RFID chip of said plurality of RFID chips.

21. The method of manufacturing strap substrates for an RFID inlay according to Claim 20 wherein placing the plurality of RFID chips onto said substrate comprises assembling said plurality of RFID chips into a plurality of recessed regions formed in said substrate.

22. The method of manufacturing strap substrates for an RFID inlay according to Claim 21 wherein placing the plurality of RFID chips into said plurality of recessed regions is performed using a self-assembly process.

23. The method of manufacturing strap substrates for an RFID inlay according to Claim 20 wherein said plurality of recessed regions are formed by:
introducing a low-viscosity curable material onto a casting apparatus having a plurality of casting patterns; and
curing said low-viscosity material to provide the substrate containing the plurality of recessed regions.

24. The method of manufacturing strap substrates for an RFID inlay according to Claim 20 wherein forming the plurality of strap pad patterns or antenna coil patterns of DER on said substrate comprises printing the DER patterns.

25. The method of manufacturing strap substrates for an RFID inlay according to Claim 20 wherein forming the plurality of strap pad patterns or antenna coil patterns of DER on said substrate comprises applying the DER by a plotter pen apparatus.

26. The method of manufacturing strap substrates for an RFID inlay according to Claim 20, further comprising separating said substrate into a plurality of strips, each strip having a succession of strap substrates, and each strap substrate including DER strap pad patterns or a DER antenna coil pattern and a corresponding RFID chip.

27. The method of manufacturing strap substrates for an RFID inlay according to Claim 26, further comprising rolling one or more of said plurality of strips onto a reel.

28. The method of manufacturing strap substrates for an RFID inlay according to Claim 26, further comprising coating longitudinal edges of the strips with DER.

29. The method of manufacturing strap substrates for an RFID inlay according to Claim 20 wherein the DER is formulated from a binder and a conductive powder.

30. The method of manufacturing strap substrates for an RFID inlay according to Claim 29 wherein the DER has a microscopic electrical volume resistivity of less than about 1000 ohm-cm.

31. The method of manufacturing strap substrates for an RFID inlay according to Claim 29 wherein the conductive powder has a mean particle size of less than about two microns.

32. The method of manufacturing strap substrates for an RFID inlay according to Claim 21 wherein, forming the plurality of DER strap pad patterns or antenna coil patterns is performed prior to placing the plurality of RFID chips into said plurality of recessed regions, and forming said plurality of DER strap pad patterns further comprises forming a plurality of DER pattern extensions that extend said plurality of DER strap pad patterns or terminals of the DER antenna coil patterns into the bottoms of the plurality of recessed regions, said plurality of DER pattern extensions configured to electrically contact contacts of said plurality of RFID chips after the plurality of RFID chips are placed into the recessed regions.

33. An RFID inlay structure, comprising:
an inlay substrate having an antenna and antenna contacts;
a strap substrate carrying an RFID chip and having at least one surface coated with a directly electroplateable resin (DER), said DER being in electrical contact with said antenna contacts and contacts of said RFID chip; and
a metal interconnection electrically connected between the contacts of the RFID chip and the antenna contacts on the inlay substrate.

34. The RFID inlay structure according to Claim 33 wherein the strap substrate has a first major surface with a recessed region configured to hold the RFID chip.

35. The RFID inlay structure according to Claim 34 wherein the recessed region is a casted recessed region.

36. The RFID inlay structure according to Claim 34 wherein the RFID chip contacts are oriented toward the bottom of the recessed region.

37. The RFID inlay structure according to Claim 33 wherein at least one edge of said strap substrate is coated with DER.

38. The RFID inlay structure according to Claim 34 wherein the DER coated surface extends into the recessed region and in electrical contact with the RFID chip contacts.

39. The RFID inlay structure according to Claim 33 wherein said DER is formulated from a binder and a conductive powder.

40. The RFID inlay structure according to Claim 39 wherein said conductive powder includes carbon black.

41. The RFID inlay structure according to Claim 39 wherein the DER has a microscopic electrical volume resistivity of less than about 1000 ohm-cm.

42. The RFID inlay structure according to Claim 39 wherein the conductive powder has a mean particle size of less than about two microns.

43. An RFID inlay structure, comprising:
a substrate;
an RFID chip disposed on said substrate; and
a pattern of directly electroplateable resin (DER) formed on said substrate and on one or more electrical contacts of said RFID chip.

44. The RFID inlay structure according to Claim 43, further comprising:
a second substrate having an antenna formed thereon; and
a metal interconnect coupled between said one or more electrical contacts of said RFID chip and antenna contact positions of said antenna.

45. The RFID inlay structure according to Claim 43 wherein said pattern comprises a loop antenna pattern.

46. A method of manufacturing a plurality of RFID inlays, comprising:
forming first electrical connections between antenna contacts on a substrate and contacts of a plurality of RFID chips of a first type; and
forming second electrical connections between antenna contacts on said substrate and contacts of RFID chips of a second type.

47. The method of manufacturing a plurality of RFID inlays according to Claim 46 wherein at least said first electrical connections of said first and second electrical connections are formed using a directly electroplateable resin (DER).

48. The method of manufacturing a plurality of RFID inlays according to Claim 46 wherein the antenna contacts corresponding to either said first or second RFID chip types are formed using a directly electroplateable resin (DER).

49. The method of manufacturing a plurality of RFID inlays according to Claim 46, further comprising:
reading one or more RFID chips of the plurality of RFID inlays using a multi-protocol reader;
processing electrical signals received from said multi-protocol reader; and
based on results of processing said electrical signals, determining whether said one or more RFID chips of the plurality of RFID inlays complies with one or more predetermined specifications.

50. The method of manufacturing a plurality of RFID inlays according to Claim 49, further comprising printing a mark or information on those RFID inlays determined to be in compliance with said one or more predetermined specifications.

51. The method of manufacturing a plurality of RFID inlays according to Claim 49, further comprising printing a mark or information on those RFID inlays determined to be not in compliance with said one or more predetermined specifications.

52. The method of manufacturing a plurality of RFID inlays according to Claim 50 wherein said printing a mark or information comprises printing using an inkjet printer.

53. The method of manufacturing a plurality of RFID inlays according to Claim 51 wherein said printing a mark or information comprises printing using an inkjet printer.

54. A method of inspecting a plurality of RFID inlays formed on a substrate, comprising:
reading RFID chips of the plurality of RFID inlays, as the substrate is moved, using an RFID reader;
from signals generated by reading the RFID chips of said plurality of RFID inlays, determining whether the RFID chips comply with one or more predetermined specifications; and
printing the RFID inlays that comply with the one or more predetermined specifications with a mark or information read from or related to information stored in the associated RFID chip.

55. The method of inspecting a plurality of RFID inlays formed on a substrate according to Claim 54 wherein the RFID chips of the plurality of RFID inlays comprise two or more different RFID chip types, and reading the RFID chips is performed by a multi-protocol reader.

56. The method of inspecting a plurality of RFID inlays formed on a substrate according to Claim 54 wherein the RFID inlays being inspected include electrical connections between antenna contacts on said substrate and contacts of associated RFID chips, the electrical connections comprising electroplated directly electroplateable resin (DER) patterns.

57. An apparatus for testing a plurality of RFID inlays containing two or more types of RFID chips, comprising:
a multi-protocol reader;
a processor in communication with the multi-protocol reader adapted to receive electrical signals from said multi-protocol reader, said electrical signals comprising or relating to information read from two or more types of RFID chips of a plurality of RFID inlays; and
a printer in communication with said processor operable to print a mark or information on surfaces of selected ones of said plurality of RFID inlays.

58. The apparatus for testing a plurality of RFID inlays according to Claim 57 wherein the processor is further operable to examine said electrical signals to determine which RFID chips of the plurality of RFID inlays comply with predetermined specifications.

59. The apparatus for testing a plurality of RFID inlays according to Claim 58 wherein the selected ones of said plurality of RFID inlays include those RFID inlays determined to have RFID chips that are compliant with the predetermined specifications.

60. The apparatus for testing a plurality of RFID inlays according to Claim 58 wherein the selected ones of said plurality of RFID inlays include those RFID inlays determined to have RFID chips that are not compliant with the predetermined specifications.
